(19) Europäisches Patentamt
European Patent Office
Office européen des brevets

(11) **EP 2 625 305 B1**

(12) **EUROPEAN PATENT SPECIFICATION**

(45) Date of publication and mention
of the grant of the patent:
**29.05.2019 Bulletin 2019/22**

(51) Int Cl.:
***C23C 14/46*** *(2006.01)*　　***C23C 14/34*** *(2006.01)*
***H01J 27/02*** *(2006.01)*　　***H01J 37/08*** *(2006.01)*

(21) Application number: **11831447.5**

(22) Date of filing: **04.10.2011**

(86) International application number:
**PCT/US2011/054759**

(87) International publication number:
**WO 2012/047882 (12.04.2012 Gazette 2012/15)**

(54) **ION BEAM DISTRIBUTION**

IONENSTRAHLENVERTEILUNG

DISTRIBUTION DE FAISCEAUX D'IONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.10.2010 US 898351
05.10.2010 US 898424
05.10.2010 US 898281**

(43) Date of publication of application:
**14.08.2013 Bulletin 2013/33**

(73) Proprietor: **Veeco Instruments Inc.
Plainview, NY 11803 (US)**

(72) Inventor: **KAMEYAMA, Ikuya
Plainview, New York 11803 (US)**

(74) Representative: **Hanna Moore + Curley
Garryard House
25/26 Earlsfort Terrace
Dublin 2, D02 PX51 (IE)**

(56) References cited:
**WO-A2-2005/024881　　WO-A2-2005/038855
JP-A- 2000 011 905　　US-A1- 2007 181 820
US-A1- 2008 164 819　　US-B2- 7 285 788**

Printed by Jouve, 75001 PARIS (FR)

## Description

### Cross-reference to Related Applications

The present application claims the benefit of priority to U.S. Patent Application No. 12/898,281, entitled "Ion Beam Distribution," and filed on October 05, 2010. The present application further claims priority to U.S. Patent Application No. 12/898,424, entitled "Plume Steering," and filed on October 05, 2010; and U.S. Patent Application No. 12/898,351, entitled "Grid Providing Beamlet Steering," and filed on October 05, 2010.

### Technical Field

The invention relates generally to ion beam systems and components thereof.

### Background

Ion beam systems, when used to sputter material off from a target to create coating on a substrate, can be referred to as ion beam sputter deposition systems. Alternatively, ion beam systems can also be used to etch material off a substrate material, in which case, the ion beam system is referred to as an ion beam etch system. Ion beam systems have other applications, including without limitation ion beam assisted deposition.

In an ion beam sputter deposition system, a sputter target is placed downstream from an ion source generating the ion beam. The ion beam is used to sputter atoms of a material from the sputter target. In such systems, individual ions having kinetic energy strike the surface of the sputter material and knock atoms of the sputter material from the sputter target. The sputter material liberated from the target surface in a plume can be directed to a substrate, which is placed to catch the plume. Such ion beam sputter deposition system can be used for, among other things, deposition of sputter material and its compound on the substrate surfaces. For example, in one implementation, an ion beam impinges a titanium sputter target to generate a coating of titanium oxide on a substrate in oxygen environment or to generate a coating of titanium nitride on a substrate in nitrogen environment.

Generally, the ion current density at various points across a cross-section of an ion beam may be uneven in a manner so that the resulting sputtering from the sputter target is not uniform across the surface of the sputter target. Typically, the ion beam intersecting the target surface is significantly smaller than the target and is roughly centered on the target in order to capture the entire beam and to minimize contamination from beam overspray. Such an arrangement provides a certain wear pattern of the sputter target that may not be advantageous for the useful life of the sputter target. For example, the sputter material in one area of the sputter target surface is sputtered substantially more than the sputter material in other areas. Such uneven sputtering results in inefficient use of the sputter target. Accordingly, a sputtering operation on a particular target is typically terminated before any area of target material is completely worn through. In such case, such unevenly utilized sputter target has to be replaced with a new sputter target, even if a substantial amount of sputter material remains on the old sputter target. Given the cost of the sputter material and the inefficiencies involved in changing the sputter targets, it is important to make more efficient and more uniform wear of the sputter target material. Published PCT application WO 2005/024881 A2 discloses a particle-optical arrangement comprising a charged-particle source for generating a beam of charged particles; a multi-aperture plate arranged in a beam path of the beam of charged particles, wherein a plurality of charged-particle beamlets is formed from the beam of charged particles downstream of the multi-aperture plate, and wherein a plurality of beam spots is formed in an image plane of the apparatus by the plurality of beamlets, the plurality of beam spots being arranged in a second array pattern; and a particle-optical element for manipulating the beam of charged particles and/or the plurality of beamlets; wherein the first array pattern has a first pattern regularity in a first direction, and the second array pattern has a second pattern regularity in a second direction electron-optically corresponding to the first direction, and wherein the second regularity is higher than the first regularity. Published PCT application WO 2005/038855 A2 discloses an electrode for a deceleration lens assembly for an ion implanter, comprising: an electrode body which defines an aperture having a periphery, a center, an axis passing through said center and defining a length of said aperture along said axis, said axis comprising a first axis segment extending from the center of the aperture toward the periphery of said aperture along said axis and having a length in the range of 20-40% of said aperture length, wherein the average width of the aperture measured at points along said axis segment is less than the width of said aperture measured at the center of said aperture.

### Summary

The present application provides a method in accordance with the claims which follow.

**Brief Descriptions of the Drawings**

A further understanding of the nature and advantages of the present invention may be realized by reference to the figures, which are described in the remaining portion of the specification. In the figures, like reference numerals may be used throughout several figures to refer to similar components. In some instances, a reference numeral may have an associated sub-label consisting of a subscript letter to denote one of multiple similar components. When reference is made to a reference numeral without specification of a sub-label, the reference is intended to refer to all such multiple similar components.

FIG. 1 illustrates an example block diagram of a beamlet steering ion beam system.
FIG. 2 illustrates an example implementation of a beamlet steering ion beam system.
FIG. 3 illustrates an example diagram of a beamlet steering grid assembly used in an ion beam system.
FIG. 4 illustrates example beamlet steering diagram using hole offsets.
FIG. 5 illustrates an example plot-diagram of total steering of beamlets generated by a beamlet steering grid assembly.
FIG. 6 illustrates an alternate example plot diagram of total steering of beamlets generated by a beamlet steering grid assembly.
FIG. 7 illustrates an example cross-sectional ion current density profile resulting from the beamlet steering.
FIG. 8 illustrates the integrative effect of the rotation of a destination work-piece and resulting average ion-current density at various locations on the destination work-piece surface.
FIG. 9 illustrates a plot-diagram of integrative ion current density profile resulting from beamlet steering.
FIG. 10 illustrates an example graph of rotationally average wear pattern generated by beamlet as a function of radius of a destination work-piece.
FIG. 11 illustrates an alternate example cross-sectional ion current density profile resulting from the beamlet steering.
FIG. 12 illustrates an alternate plot-diagram of integrative ion current density profile resulting from beamlet steering.
FIG. 13 illustrates an alternate example graph of rotationally average wear pattern generated by beamlet as a function of radius of a destination work-piece.
FIG. 14 illustrates example operations for generating substantially uniform destination work-piece wear.

**Detailed Descriptions**

In the following description, for the purposes of explanation, numerous specific details are set forth in order to provide a thorough understanding of the present invention. It will be apparent, however, to one skilled in the art that the present invention may be practiced without some of these specific details. For example, while various features are ascribed to particular implementations, it should be appreciated that the features described with respect to one implementation may be incorporated with other implementations as well. Similarly, however, no single feature or features of any described implementation should be considered essential to the invention, as other implementations of the invention may omit such features.

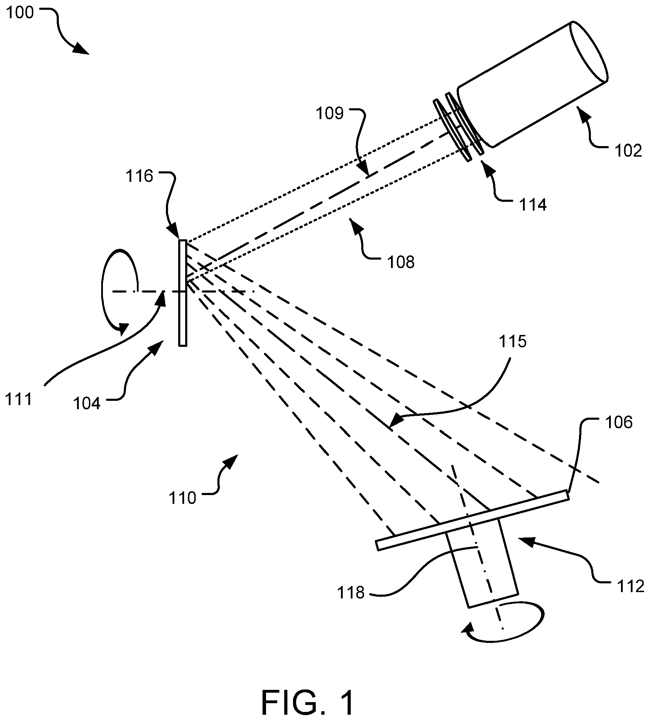

FIG. 1 illustrates an example block diagram of a beam steering ion beam system 100. Even though the implementation of the ion beam system 100 is implemented as an ion beam sputter deposition system, components of the ion beam system 100 may also be used with some alteration for implementing an ion beam etch system, an ion implantation system, an ion beam deposition system, an ion beam assisted deposition system, etc.

In the illustrated implementation, the ion beam system 100 includes an ion source 102, a work-piece sub-assembly 104, and a substrate assembly 106. The ion beam source 102 generates an ion beam 108 that includes a plurality of ion beamlets. The ion source 102 has a centerline axis 109 that is targeted or directed toward work-piece sub-assembly 104 such that the ion beam 108 completely or near completely intersects the plan of work-piece sub-assembly 104. The ion beam 108, upon striking the work-piece sub-assembly 104, generates a sputter plume 110 of material from a target affixed to a work-piece surface 116 of the work-piece sub-assembly 104. The ion beam 108 strikes the work-piece sub-assembly 104 at such an angle so that the sputter plume 110 generated from the work-piece sub-assembly 104 travels towards the substrate assembly 106. In one implementation of the ion beam system, the sputter plume 110 is divergent as it travels towards the substrate assembly 106 and may partially overspray substrate assembly 106. However, in an alternate implementation, the sputter plume 100 may be made more or less concentrated so that its resulting deposition of material is more effectively distributed over a particular area of the substrate 106.

The substrate assembly 106 is located such that the sputter plume 110 strikes the substrate affixed to the substrate assembly 106 at a desired angle as well. Note that the substrate assembly may refer to a single large substrate or a sub-assembly holder that holds multiple smaller individual substrates. In one example implementation of the ion beam system 100, the substrate assembly 106 is attached to a fixture 112 that allows the substrate assembly 106 to be rotated or moved in a desired manner, including rotation of substrate assembly 106 about its axis 118 or pivoting the fixture 112 to tilt the substrate assembly axis 118 to alter its angle with respect to the sputter plume 110.

In an implementation where the substrate assembly includes a substrate that is being treated, such a substrate in the substrate assembly 106 may be a single or arrayed batch of substantially planar work-pieces such as wafers or optical lenses. Alternatively, in such implementation where the substrate is being treated, the substrate in the substrate assembly 106 may be a single or arrayed batch of work-pieces that has additional 3D features, such as cubic (or faceted) optical crystals, curved optical lenses or cutting tool inserts, for example. In addition, such work-pieces may be masked with mechanical templates or patterned etch resist layers (i.e. photo-resist) to help facilitate selected patterning of deposited films or ion treatment over the surface areas of the work-pieces.

In one implementation of the ion beam system 100, the ion source 102 generates ions that are positively charged. However, in an alternate implementation, the ion source 102 may generate ions that are negatively charged. The subsequent disclosure herein assumes that the ions generated by the ion source 102 are positively charged. The ion source 102 may be a DC type, a radio frequency (RF) type or a microwave type gridded ion source. In such an implementation, a steering structure including a plurality of grids 114 is positioned in the path of the ion beam 108. In one implementation of the ion beam system 100, grids 114 are used to direct the ion beam 108 on the work-piece sub-assembly 104 in a desired manner. In one implementation of the ion beam system 100, the plurality of grids 114 steer the ion beamlets such that the ion beam 108 is divergent from the centerline axis 109 of the ion source 102 if no bulk ion beam steering was provided. In an alternate implementation, the plurality of grids 114 steers the ion beamlets such that the ion beam 108 is not divergent from the centerline axis 109. Alternate implementation may also be provided. As discussed below in further detail, in an example implementation, the grids 114 cause the ion beam 108 to have a symmetric or asymmetric cross-sectional profile around a beam axis.

In one implementation, the individual holes in the grids 114 may be positioned to yield the highest density of holes per area to maximize ions extracted from the ion source 102. In another implementation, the grids 114 may have a rectilinearly or elliptically shaped pattern of holes. Individual holes in a rectilinear or elliptical shaped acceleration grid may be positioned to steer beamlets in a circularly asymmetric distribution. Further, holes in a rectilinearly shaped acceleration grid may be positioned relative to corresponding holes in a rectilinearly shaped screen grid, wherein each offset provides for individual steering angles. In other words, a first beamlet may pass through a first hole in the acceleration grid at a first steering angle. A second beamlet may pass through a second hole in the acceleration grid, adjacent to the first hole, at a second steering angle different from the first steering angle. A third beamlet may pass through a third hole in the acceleration grid, adjacent to the second hole, at a third steering angle different from the second steering angle.

The work-piece sub-assembly 104 is located on a platform (not shown in FIG. 1) that rotates the work-piece sub-assembly 104 about a given axis 111 of a work-piece surface 116. In the implementation illustrated in FIG. 1, the work-piece surface 116 is positioned in a manner so that the ion beam 108 strikes the work-piece surface 116 asymmetrically. As further illustrated below, such asymmetric alignment of the work-piece surface 116 together with its rotation around its axis allows more uniform application of the ion beam on the work-piece surface 116. In one implementation of the ion beam system 100, the target affixed to the work-piece surface 116 is made of a single material, and multiple work-piece surfaces 116 with different materials may be placed and interchanged so that a layer of materials can be deposited to create multi-layer coatings on the surface of substrates in the substrate assembly 106. Examples of such material to be deposited on the substrates include without limitation metallic, such as silicon (Si), molybdenum (Mo), tantalum (Ta), etc., oxides such as silicon dioxide ($SiO_2$), tantalum pentaoxide ($Ta_2O_5$), titanium dioxide ($TiO_2$), etc, and other compounds.

In the implementation illustrated in FIG. 1, the sputter plume 110 is directed to the substrate assembly 106 so that a centerline 115 of the sputter plume is off a central axis 118 of the substrate assembly 106. Furthermore, the sputter plume 110 may be directed to the sputter assembly 106 such that in one implementation, at least some sputter material is sprayed in area around and away from the substrate assembly 106, resulting in overspray. Note that in the implementation shown in FIG. 1, the sputter plume oversprays the substrate assembly 106; in an alternate implementation, the sputter plume may impinge on an area confined to the surface of the substrate assembly 106. In one implementation, the sputter assembly 106 is designed so that it may be rotated around a central axis 118. In an implementation of the ion beam system 100, the target surface 116 is tilted as to the centerline 109. In an alternate embodiment, the substrate 106 is tilted as to the centerline 115 of the sputter plume.

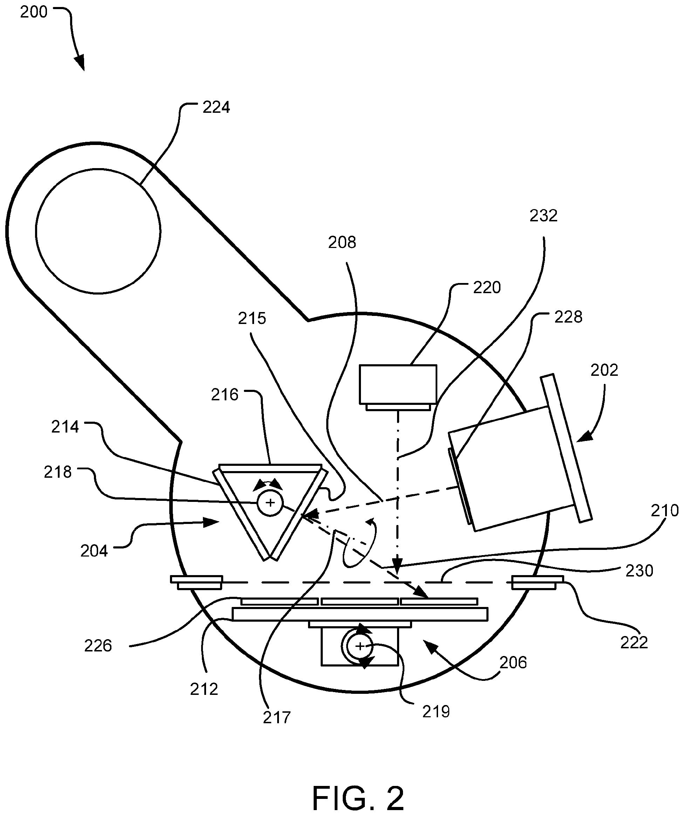

FIG. 2 illustrates an example implementation of a beam steering ion beam system. Specifically, FIG. 2 illustrates a top-down view of a dual ion beam system 200. The ion beam system 200 includes a first RF ion source 202, a target assembly 204, and a substrate assembly 206. The substrate assembly may be tilted around an axis 219. The first RF ion-source 202 generates an ion-beam 208 that is directed towards the target assembly 204. The target assembly 204, upon interaction with the ion-beam 208, generates a sputter plume 210 that is used for deposition on a substrate 226 of the substrate assembly 206. The ion beam system 200 may include a chamber door 222 to effect vacuum conditions in the ion beam system 200. In the illustrated implementation, the chamber door 222 is connected to a door assembly 230 used in maintaining vacuum conditions in the ion beam system 200 as necessary. In one implementation, the substrate 226 is made of a single or arrayed batch of substantially planar work-pieces such as wafers or optical lenses. In an alternate implementation, the substrate 226 is made of a single or arrayed batch of work-pieces that may have additional 3D features, such as cubic (or faceted) optical crystals, curved optical lenses or cutting tool inserts, for example. In addition, such work-pieces may be masked with mechanical templates or patterned etch resist layers (i.e. photo-resist) to help facilitate selected patterning of deposited films or ion treatment over the surface areas of the work-pieces.

The target assembly 204 includes a plurality of target surfaces 214, 215, 216. In one implementation of the ion beam system 100, the target assembly 204 is designed to allow the target surfaces 214, 215, 216 to index around an axis 218 to change from one target 215 to another target 214 or 216. In one implementation of the ion beam system 200, each of the target surfaces 214, 215, 216 have a different material on its surface. Alternatively, the same material may be used on all target surfaces 214, 215, 216. In an alternate implementation, the angle of the active target surface 215 is changed to an alternate static angle relative to the ion beam 208 during deposition. Alternatively, the angle of the active target surface 215 can be oscillated over a range of angles during deposition to help distribute wear across the target surface and to improve deposition uniformity. In an alternate implementation, the work-piece 215 may also be rotated around an axis 217. In an alternate implementation, a second RF ion-source 220 is provided to assist the deposition of the sputter plume 210 on the substrate 226. In one implementation of the ion beam system 100, a gating mechanism (not shown) is used to manage the amount and location of the deposition of the sputter plume 210 on the substrate 226. In one example implementation, the second ion source 220 generates an ion beam 232 that is directed toward the substrate assembly 206. Such an assisting ion beam 232 may be used to either pre-clean or pre-heat the surface of the substrate 226. In an alternate implementation, the assisting ion beam 232 is used in combination with the arrival of material from sputter plume 210 to enhance the surface film deposition kinetics (i.e., material deposition, surface smoothing, oxidation, nitridation, etc.) on substrate 226. In an alternate implementation, the assisting ion beam 232 is used to make deposition of sputter material more dense (or packed) and/or to make the deposition surface smoother.

An implementation of the ion beam system 200 is provided with a vacuum system plenum 224 to generate vacuum condition inside the ion beam system 200. The substrate assembly 206 may be provided with a rotating mechanism to effectively generate a planetary-motion substrate 226. The substrate assembly 206 may also be tilted to alternate angles around an axis 219 either statically or dynamically during deposition in order to improve deposition uniformity across the substrate. The first RF ion-source 202 may also include a plurality of grids 228 located in the path of the ion-beam 208 to target or direct the ion-beam in a desired manner.

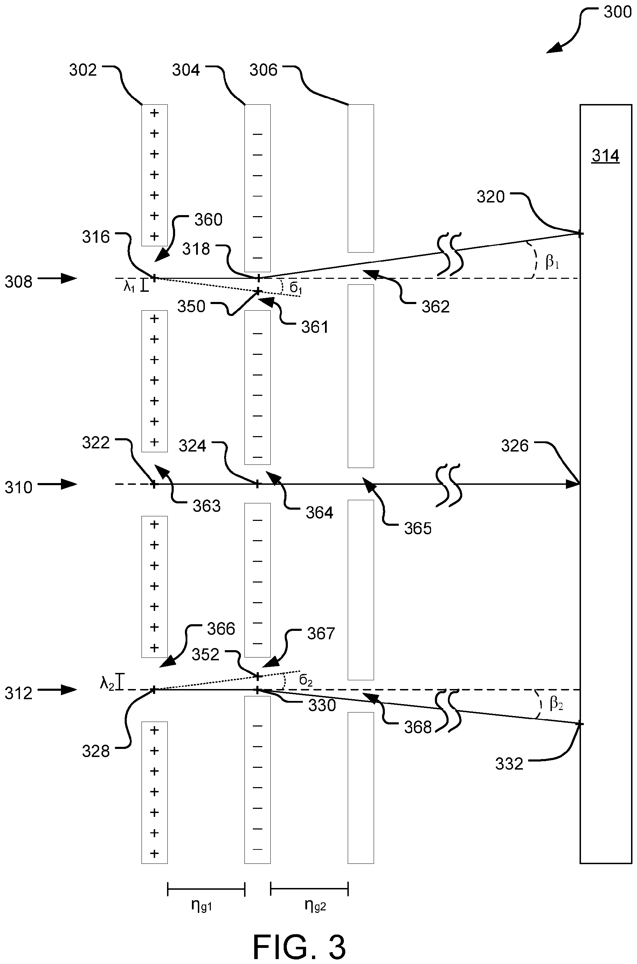

FIG. 3 illustrates an example diagram of a grid assembly 300 used in an ion beam system. The grid assembly 300 comprises a screen grid 302, an acceleration grid 304, and a deceleration grid 306 shown in a cross-sectional view, although it should be understood that different combinations of grids may be employed, including configurations employing a larger number or a fewer number of grids. In one implementation, the grids are circular in shape, with each grid having a substantially similar diameter, although other shapes are contemplated. In another implementation, the grids may have a concave or a convex dished shape.

As shown in FIG. 3, the three grids 302, 304, and 306 are positioned parallel to one another with a distance between each grid measured as $\eta_{g1}$ and $\eta_{g2}$. While the grids are shown positioned parallel to one another, this characteristic is not required. In some implementations, the grids may be slightly non-parallel with slightly varying distances $\eta_{g1}$ and $\eta_{g2}$ across the faces of the grids. The grids 302, 304, and 306 are manufactured with an array of corresponding holes. In one implementation, the grids are substantially circular in shape with a substantially circular array of holes, although other grid shapes and hole arrays are contemplated, for example rectangular and elliptical. The grids 302, 304, and 306 are positioned such that the screen grid 302 forms the downstream boundary of a discharge chamber of an ion source (not shown). The discharge chamber generates a plasma of positively charged ions (e.g., from a noble gas, such as argon), and the grids 302, 304, and 306 extract and accelerate ions from the plasma through the grid holes toward a work piece 314 (e.g., a sputter target or substrate). In one implementation, the work piece 314 may be a single or arrayed batch of substantially planar substrates such as wafers or optical lenses or, alternatively, a single or arrayed batch of work pieces that may have additional 3D features, such as cubic (or faceted) optical crystals, curved optical lenses or cutting tool inserts, for example. In addition, such work pieces may be masked with mechanical templates or patterned etch resist layers (i.e. photo-resist) to help facilitate selected patterning of deposited films or ion treatment over the surface areas of the work pieces.

Three holes for each grid are shown to illustrate how beamlet steering is achieved for various grid holes that may be applied across the grid assembly system. The work piece 314 may be oriented at an angle relative to the grids 302, 304, and 306. The ions are organized in a collimated ion beam made up of individual beamlets, wherein a beamlet comprises ions accelerating through individual sets of corresponding holes in the grids 302, 304, and 306.

In practice, individual ions of each beamlet flood generally along a center axis through a hole in the screen grid 302 in a distribution across the open area of the hole. The beamlet ions continue to accelerate toward the acceleration grid 304, flooding generally along a center axis through a corresponding hole of the acceleration grid 304. Thereafter, the momentum imparted by the acceleration grid 304 on the beamlet ions propels them generally along a center axis through a hole in the deceleration grid 306 in a distribution across the open area of the hole and toward a downstream positioned work piece 314.

The screen grid 302 is closest to the discharge chamber and is therefore the first grid to receive the emission of ions from the discharge chamber. As such, the screen grid 302 is upstream of the acceleration grid 304 and the deceleration grid 306. The screen grid 302 comprises a plurality of holes strategically formed through the grid. All of the holes in the screen grid 302 may have the same diameter or may have varying diameters across the face of the screen grid 302. Additionally, the distance between the holes may be the same or of varying distances. The screen grid 302 is illustrated in FIG. 3 as four vertical bars in a single column separated by spaces representing three drilled holes 360, 363, and 366 within the screen grid 302. The screen grid 302 is marked with plus (+) signs, representing the screen grid 302 as being positively charged or biased.

The acceleration grid 304 is positioned immediately downstream of the screen grid 302 in FIG. 3, separated by a distance $\eta_{g1}$. As such, the acceleration grid 304 is downstream of the discharge chamber and the screen grid 302 and upstream of the deceleration grid 306. The acceleration grid 304 comprises a plurality of holes strategically drilled through the grid, each hole generally corresponding to a hole in the screen grid 302. Although holes are often formed by drilling, they may also be formed by other methods or combinations of methods including but not limited to milling, reaming, electro discharge machining (EDM), laser machining, water jet cutting and chemical etching. In one implementation, both the acceleration grid 304 and the screen grid 302 include the same number of holes. However, additional implementations may provide for a differing number of holes between the acceleration grid 304 and the screen grid 302. All of the holes in the acceleration grid 304 may have the same diameter or may have varying diameters across the face of the acceleration grid 304. Additionally, the distance between the holes may be the same or of varying distances. The acceleration grid 304 is illustrated in FIG. 3 as four vertical bars in a single column separated by spaces representing three drilled holes 361, 364, and 367 within the acceleration grid 304. The acceleration grid 304 is marked with minus (-) signs, representing that the acceleration grid 304 as being negatively charged or biased. A negative charge or bias on the acceleration grid 304 extracts the ions from the plasma and through the holes in the screen grid 302.

The deceleration grid 306 is positioned immediately downstream of the acceleration grid 304 in FIG. 3, separated by a distance $\eta_{g2}$. As such, the deceleration grid 306 is downstream of the discharge chamber, the screen grid 302 and the acceleration grid 304 and upstream of the work piece 314. The deceleration grid 306 comprises a plurality of holes strategically drilled through the grid, each hole generally corresponding to a hole in the acceleration grid 304. In one implementation, both the deceleration grid 306 and the acceleration grid 304 include the same number of holes. However, additional implementations may provide for a differing number of holes between the acceleration grid 304 and the deceleration grid 306. All of the holes in the deceleration grid 306 may have the same diameter or may have varying diameters across the face of the deceleration grid 306. Additionally, the distance between the holes may be the same or of varying distances. The deceleration grid 304 is illustrated in FIG. 3 as four vertical bars in a single column separated by spaces representing three drilled holes 362, 365, and 368 within the deceleration grid 306. The deceleration grid 306 is typically grounded or charged with a small negative potential or bias.

As ions pass through holes in the deceleration grid 306, the ions collide into the downstream positioned work piece 314, such as a sputter target or substrate. While the work piece 314 is shown parallel to the grids 302, 304, 306 it may also be at any arbitrary angle suitable for a particular application. In a sputtering operation, it is possible to use multiple sputter targets, wherein each target may have a different material affixed to its surface. As ions collide with the surface of a target, an amount of material from the target separates from the surface of the target, traveling in a plume toward another work piece, such as a substrate to coat the surface of a substrate (not shown). With multiple targets of differing material coats, multi-layer coatings may be created onto a single substrate.

FIG. 3 shows three ions 308, 310, and 312 passing through adjacently positioned holes in the three grids 302, 304, and 306 and colliding into the surface of the work piece 314. However, it should be understood that the three ions 308, 310, and 312 generally represent a distribution of ions flooding through the holes in the three grids 302, 304, and 306. The trajectory of the representative ion 308 is altered (e.g., in an upward direction) as the ion 308 approaches and passes through the hole 361of the acceleration grid 304. The altered trajectory results from an offset in the hole 361 of the acceleration grid 304 relative to the adjacent hole 360 in the screen grid 302, which causes the ion 308 to travel closer to the top circumference of the acceleration grid hole 361. In this configuration, the ion 308 experiences a greater electrostatic attraction to the top circumference of the acceleration grid hole 361 as compared to the bottom circumference, which alters the trajectory of the ion 308 relative to an orthogonal center axis 350 through the acceleration grid hole 361.

In contrast, the trajectory of the ion 312 is altered in the opposite direction (e.g., downward) as the ion 312 approaches and passes through the hole 367 of the acceleration grid 304. The hole 367 of the acceleration grid 304 is also offset relative to the adjacent hole 366 of the screen grid 302. As with ion 308, the altered trajectory of ion 312 results from an intentional offset in the hole 367 of the acceleration grid 304 relative to the adjacent hole 366 in the screen grid 302, which causes the ion 312 to travel closer to the bottom circumference of the acceleration grid hole 367. In this configuration, the ion 312 experiences a greater electrostatic attraction to the bottom circumference of the acceleration grid hole 367 as compared to the top circumference, which alters the trajectory of the ion 312 relative to an orthogonal center axis 352 through the acceleration grid hole 367.

In contrast to the preceding examples of intentionally altered trajectories, the trajectory of ion 310 remains on the center axis 324 of the hole 364 of the acceleration grid 304. The trajectory of the ion 310 is unaltered because the hole 364 of the acceleration grid 304 is centered (e.g., no offset) relative to the hole 363 of the screen grid 302. In other words, the center axis (i.e., the centerline of the hole) 324 of the hole 364 of the acceleration grid 304 has the same Y-axis location as the center axis 322 of the hole 363 of the screen grid 302. The following paragraphs provide details of the alteration of an ion's trajectory as it passes through the three grids 302, 304, and 306. It is noted, that while FIG. 3 refers to offsets in the X-Axis and Y-Axis plane, the offsets may also exist in a Y-Axis and Z-Axis (not shown) plane.

As stated above, some of the holes in the acceleration grid 304 are offset relative to the adjacently positioned holes in the screen grid 302. In other words, the center axis from one of the holes in the acceleration grid 304 may be offset from the center axis from a corresponding hole of the screen grid 302. The trajectory of ion 308 illustrates an example where the hole 361 of the acceleration grid 304 is offset relative to the adjacent hole 360 of the screen grid 302. A screen grid center axis 316 of the hole 360 in the screen grid 302 has a different Y-axis location compared to an acceleration grid center axis 350 of the hole 361 of the acceleration grid 304. In this example, $\lambda_1$ represents the Y-axis distance between the screen grid center axis 316 and the acceleration grid center axis 350. Further, $\delta_1$ represents the offset angle of the acceleration grid center axis 350 relative to the screen grid center axis 316, based on the grid separation $\eta_{g1}$.

In the illustrated implementation, location 318 illustrates the Y-axis location where the ion 308 passes through the hole 361 of the acceleration grid 304. In this example, location 318 is offset above the acceleration grid hole center axis 350 by a distance of $\lambda_1$. As the ion 308 approaches location 318, the negatively charged acceleration grid 304 electrostatically attracts the positively charged ion 308 towards the closest circumferential portion of the hole 361 of the acceleration grid. In result, the trajectory of the ion 308 is altered or steered in an upward direction as represented by the solid line extending to the work piece 314. The dashed line represents the unaltered trajectory of the ion 308 if the ion was not electrostatically steered by the intentionally configured offset between the center axes of the holes. In one implementation, as the ion 308 approaches the hole 361 of the acceleration grid 304, the electrostatic attraction begins to increase to a maximum point when the ion 308 is within the hole 361 of the acceleration grid 304. Additionally, as the ion 308 passes through the hole 361 of the acceleration grid 304 the electrostatic attraction diminishes.

Next, the ion 308 passes through the hole 362 of the deceleration grid 306. As stated above, the deceleration grid can be grounded with a neutral charge or zero electrical potential. Therefore, the deceleration grid does not substantially alter the trajectory of the ion 308, as the ion 308 passes through the hole 362 of the deceleration grid 306. In one implementation, the diameter of the hole 362 of the deceleration grid 306 is only marginally larger than the diameter of the ion beamlet exiting the acceleration grid 304. In another implementation, the hole 362 of the deceleration grid 306 is positioned such that the ion 308 passes through the center of the hole 362.

After the ion 308 passes through the hole 362 of the deceleration grid 306, the ion 308 collides into the surface of the work piece 314 at location 320. As previously stated, the dashed line represents the unaltered trajectory of the ion 308 if the ion was not electrostatically steered to alter its trajectory from the center axis 316 of the screen grid 302. A beam deflection angle, $\beta_1$, represents the angle between the centerline of a beamlet of ions with an altered trajectory and the centerline of a beamlet of ions with an unaltered trajectory. In other words, angle $\beta_1$ represents the steering angle of a beamlet relative to a non-steered beamlet.

The above example, illustrates the trajectory of a single ion 308. However, a single stream of ions, known as an ion beamlet, passes through the apertures of the group of holes 360, 361, and 362 of the three grids in a distribution across the open area of the holes. Accordingly, the position of each ion may vary slightly from the position of the ion 308. As such, the overall trajectory of successive ions may also vary slightly from the trajectory of ion 308. Further, the location where successive ions collide into the work piece 314 may also vary slightly.

The ion 310 is illustrated as passing through the apertures of the group of holes 363, 364, and 365 in the grid assembly 300. The ion 310 first passes through the hole 363 at the screen grid hole center axis 322. Next, the ion 310 passes through the hole 364 of the acceleration grid 304 at the acceleration grid hole center axis 324. In this example, the acceleration grid hole center axis 324 is aligned with the screen grid hole center axis 322. In other words, there is no substantial or intentional Y-axis differential or offset between the center axis of the holes 363, 364, and 365 of the screen grid 302 and the acceleration grid 304. Since the acceleration grid hole center axis 324 is as aligned with the screen grid hole center axis 322, there is no dominant lateral electrostatic attraction from the acceleration grid 304. Therefore, the trajectory of ion 310 remains unaltered as the ion passes through the hole 364 of the acceleration grid 304.

The ion 312 is illustrated as passing through the apertures of the group of holes 366, 367, and 368 in the grid assembly 300. In this example, the ion 312 first passes through the hole 366 of the screen grid 302. The screen grid hole center axis 328 represents the center of the hole 366 of the screen grid 302. The center axis 352 of the hole 367 of the acceleration grid 304 is offset relative to the center axis 328 of the hole 366 of the screen grid 302. As such, the acceleration grid hole center axis 352 of the hole 367 in the acceleration grid 302 has a different Y-axis location compared to the screen grid hole center axis 328 of the hole 366 of the screen grid 302. In this example, $\lambda_2$ represents the Y-axis distance between the screen grid hole center axis 328 and the acceleration grid hole center axis 352. $\delta_2$ represents

the offset angle of the acceleration grid hole center axis 352 relative to the screen grid hole center axis 328.

In the illustrated implementation, location 330 illustrates the Y-axis location where the ion 312 passes through the hole 367 of the acceleration grid 304. In this example, location 330 is offset below the acceleration grid hole center axis 352 by a distance of $\lambda_2$. As the ion 312 approaches location 330, the negatively charged acceleration grid 304 electrostatically attracts the positively charged ion 312 towards the closest circumferential portion of the hole 367 of the acceleration grid 304. In result, the trajectory of the ion 312 is altered or steered in a downward direction as represented by the solid line extending to the work piece 314. The dashed line represents the unaltered trajectory of the ion 312 if the ion was not electrostatically steered by the intentionally configured offset between the center axes of the holes. In one implementation, as the ion 312 approaches the hole 367 of the acceleration grid 304, the electrostatic attraction begins to increase to a maximum point when the ion 312 is within the hole 367 of the acceleration grid 304. Additionally, as the ion 312 passes through the hole 367 of the acceleration grid 304 the electrostatic attraction diminishes.

Next, the ion 312 passes through the hole 368 of the deceleration grid 306. As stated above, the deceleration grid can be grounded or charged with small negative potential or bias. Therefore, the deceleration grid does not substantially alter the trajectory of the ion 312, as the ion 312 passes through the hole 368 of the deceleration grid 306. In one implementation, the diameter of the hole 368 of the deceleration grid 306 is only marginally larger than the diameter of the ion beamlet. In another implementation, the hole 368 of the deceleration grid 306 is positioned such that the ion 312 passes through the center of the hole 368.

After the ion 312 passes through the hole 368 of the deceleration grid 306, the ion 312 collides into the surface of the work piece 314 at location 332. As previously stated, the dashed line represents the unaltered trajectory of the ion 312 if the ion was not electrostatically steered to alter its trajectory from the center axis 328 of the screen grid 302. A beam deflection angle, $\beta_2$, represents the angle between the centerline of a beamlet of ions with an altered trajectory and the centerline of a beamlet of ions with an unaltered trajectory. In other words, angle $\beta_2$ represents the steering angle of a beamlet relative to a non-steered beamlet.

A maximum deflection or steering angle of a beamlet exists resulting in a maximum distance the trajectory of a beamlet can be altered as the ions collide into the work piece 314. For beamlet steering using either a two or three grid assembly, the range of deflection angle is typically between 0 and 10 degrees in general practice, above which energetic ion impingement of the accelerator grid 304 by ions at the periphery of the beamlet can become a grid design or performance consideration.

In one implementation, it is possible to include one or more grids downstream of the acceleration grid 304 with appropriate hole size, relative offset and voltage settings to further increase the net steering angle of a beamlet. For example, in one implementation, a fourth grid (not shown) may be positioned between the acceleration grid 304 and the deceleration grid 306 to further alter or steer a beamlet (e.g., beyond the range of a steering angle of a three-grid assembly). In order to extend the range of the steering angle of a beamlet, the fourth grid includes a hole positioned adjacent to and yet offset from the adjacent hole from the acceleration grid 304. Further, the fourth grid may have the opposite charge polarity of ions passing through the hole. Once an ion passes through a hole in the acceleration grid 304, the ion approaches the corresponding hole in the fourth grid. The offset of the hole in the fourth grid is positioned to further attract the ion in substantially the same direction as the adjacent hole from the acceleration grid 304. Therefore, the trajectory of the ion can be further steered beyond the range of a steering angle of a three-grid assembly. In another implementation, additional grids may be used in various combinations to further increase the range of a steering angle of a four-grid assembly or to otherwise alter the trajectories of individual beamlets.

A number of factors influence the maximum deflection or steering angle of an ion beamlet as it approaches and passes through a hole of the acceleration grid 304. As previously stated, the Y-axis distance ($\lambda$) between a screen grid hole center axis and an acceleration grid hole center axis affects the steering of an ion beamlet. In other words, the greater the distance $\lambda$, the more an ion beamlet may be steered. Additionally, the distance ($\eta_{g1}$) between a screen grid and an acceleration grid affects the steering of an ion beamlet. The voltage applied to the acceleration grid also affects the steering an ion beamlet. In one implementation, the voltage applied to the screen grid may between 50 volts (V) and 10 kilovolts (kV). The voltage applied to the acceleration grid may be between -50V and -10 kV.

An electric field is present on both the upstream side and downstream side of the acceleration grid 304. For example, the electric field on the upstream side of the acceleration grid 304 is a voltage differential divided by the distance ($\eta_{g1}$) between the screen grid 302 and the acceleration grid 304. In one implementation, a formula for determining an amount of steering of an ion beamlet (e.g., beam deflection or steering angle $\beta$) is:

$$\beta \equiv \left( -\lambda / 4\eta_{g1} \right)\left( 1 - (E_2 / E_1) \right)$$

In this formula, the unit of measurement for $E_1$ and $E_2$ is volts / mm. $E_1$ is calculated as [(voltage of the screen grid - voltage of the acceleration grid) / $\eta_{g1}$]. $E_2$ is calculated as [(voltage of the acceleration grid - voltage of the deceleration grid) / $\eta_{g2}$]. $\lambda$ is a measure of the distance between the screen grid center axis and the acceleration grid

center axis. $\eta_{g1}$ is a measure of the lateral distance between the screen grid and the acceleration grid. $\eta_{g2}$ is a measure of the lateral distance between the acceleration grid and the deceleration grid. It is noted that the above formula is but one example for calculating a beam deflection angle. Other formulae may be used to arrive at a predetermined beam deflection angle. Further, some variables may be omitted or additional variables added to a formula. In one implementation, the thickness of one or more grids may be considered in a formula for calculating a beam deflection angle.

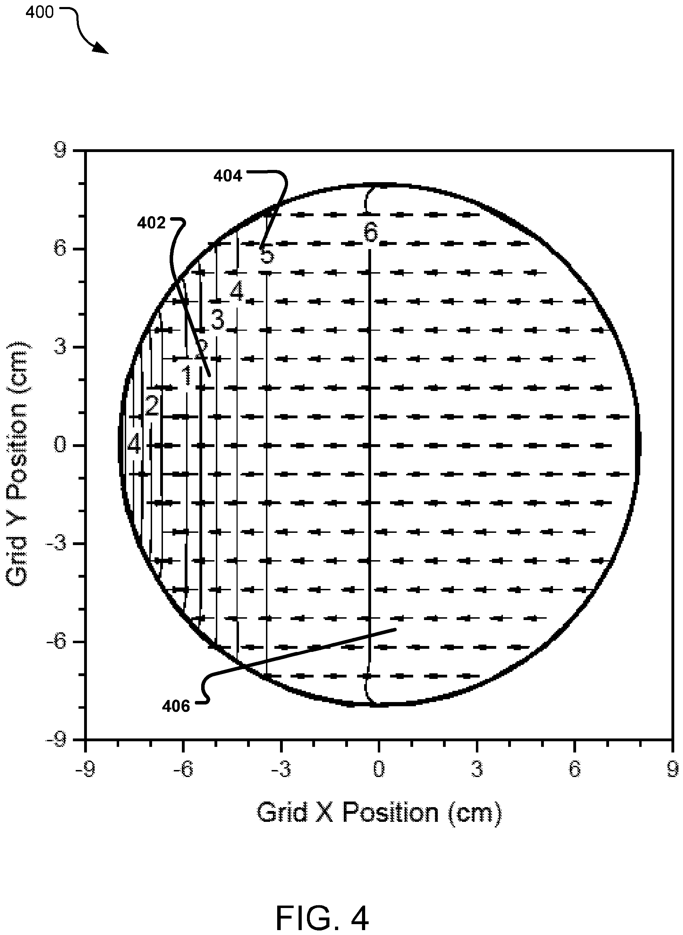

FIG. 4 illustrates an example beamlet steering diagram 400. The beamlet steering diagram 400 illustrates an ion beam cross-section with arrows indicating beamlet steering directions at X-Y locations on the grid surface and numerals (i.e., 1, 2, 3, 4, 5, and 6) indicating beamlet steering magnitude in degrees at X-Y locations on the grid surface.

In this example, beamlets are generally being steered toward the left side of the ion beam exiting the beam grid when facing the grid surface. At an X-Y location 402, the magnitude of steering is one degree. Note that a vertical line passing through location 402 denotes multiple points where the magnitude of steering is one degree. Note also that the arrows reverse direction near location 402, wherein the magnitude of steering is one degree. At an X-Y location 404, the magnitude of steering is four degrees. Note that a vertical line passing through location 404 denotes multiple points where the magnitude of steering is four degree. At an X-Y location 406, the magnitude of steering is six degrees. Note that a vertical line passing through location 406 denotes multiple points where the magnitude of steering is six degree. Thus, beamlet steering diagram 400, in effect, provides a contour plot of the magnitude of beamlet steering at various X-Y locations on the grid surface, together with the direction of such steering as depicted by the arrows.

In the beamlet steering diagram 400, the arrows indicate a generally leftward steering of the beamlets. Additional implementations may permit individual beamlets to be steered in varying directions across an X-Y plane. For example, an upper right portion of beamlets may be steered generally in a downward direction with individual beamlets from the upper right portion being steered at varying steering angles (e.g., 1 degree, 4 degrees, 6 degrees, etc.). A lower left portion of beamlets may be steered generally in an upward direction with individual beamlets from the lower left portion being steered at varying steering angles (e.g., 1 degree, 4 degrees, 6 degrees, etc.). Further, an upper left portion of beamlets' trajectories may remain unaltered, such that no offsets exist between holes in an upper left portion of an acceleration grid relative to holes in an upper left portion of a screen grid. A lower right portion of beamlets may be steered generally in an upper left direction with individual beamlets from the lower right portion being steered at varying steering angles (e.g., 1 degree, 4 degrees, 6 degrees, etc.). It is noted that varying examples may be used to circularly asymmetrically steer beamlets. As such, beamlet steering using hole offsets and grid dishing should not be limited by the illustrated examples above.

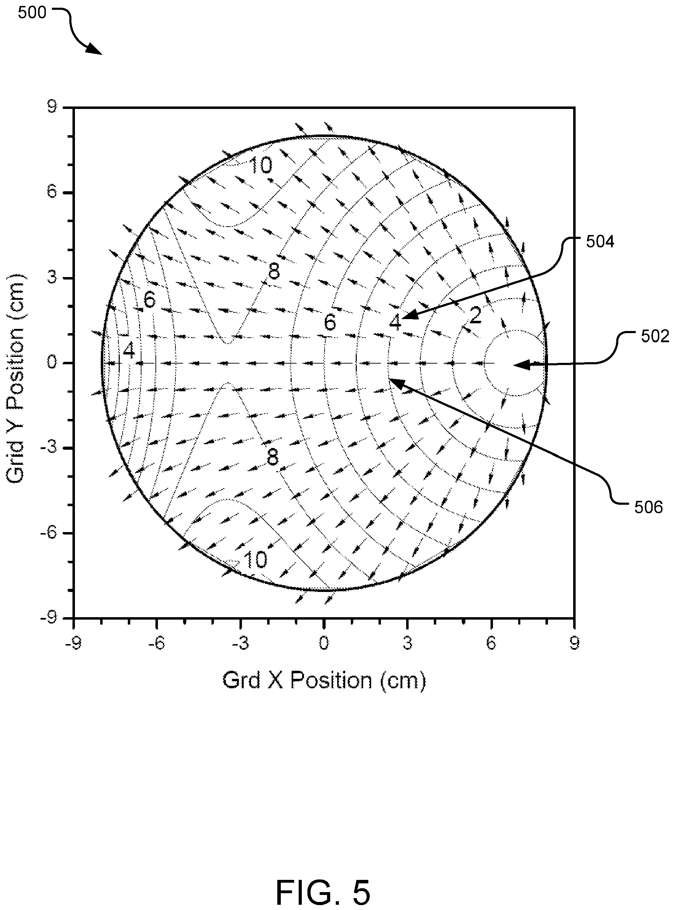

FIG. 5 illustrates an example beamlet steering diagram 500 using grid dishing and hole offsets for steering a single-peak ion beam. The diagram 500 is a combination of the beamlet steering provided by dishing and the beamlet steering provided by hole offsets. The beamlet steering diagram 500 is designed to yield an ion beam current density profile illustrated in further detail below. The beamlet steering diagram 500 illustrates beamlets generally being steered toward the left side of the ion beam exiting the grids when facing the grid surface (e.g., looking at the ion source 102 from within the ion beam 108 of FIG. 1).

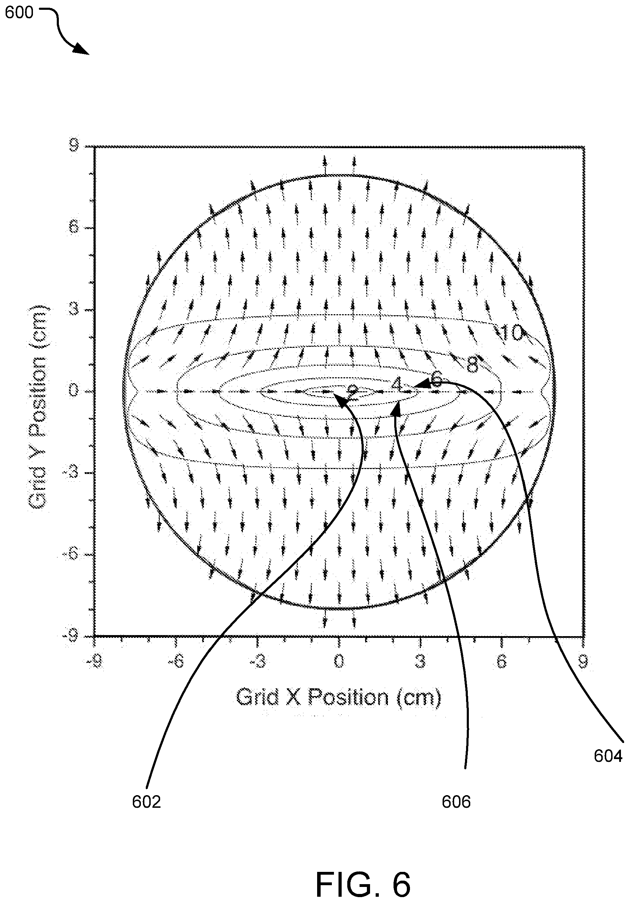

More specifically, the plot-diagram 500 illustrates total steering of an ion beam generated by a beam steering grid assembly. In FIG. 5, the arrows notify the direction of steering of ion beamlets at particular X-Y locations on the grid surface. The numerals (2, 4, 6, 8, and 10) in FIG. 5 illustrate the magnitude in degrees of steering of various ion beamlets at particular X-Y locations on the grid surface. Thus, for example, in one implementation, at an X-Y location 502, the magnitude of steering is close to zero (0) degree, whereas at an X-Y location 504, the magnitude of steering is four (4) degrees. Note that an entire arc 506 passing through the location 504 denotes locations where the magnitude of steering is equal to four (4) degrees. Thus, the plot-diagram 500, in effect, provides a contour plot of the magnitude of beamlet steering at various X-Y locations on the grid surface, together with the direction of such steering as depicted by the arrows. The plot-diagram 500 represents steering of ion beamlets for a particular implementation of the ion beam system 100. However, for an alternate fixture related grid design, an alternate steering scheme may be used that is represented by an alternate plot diagram, such as the one discussed below with respect to FIG. 6.

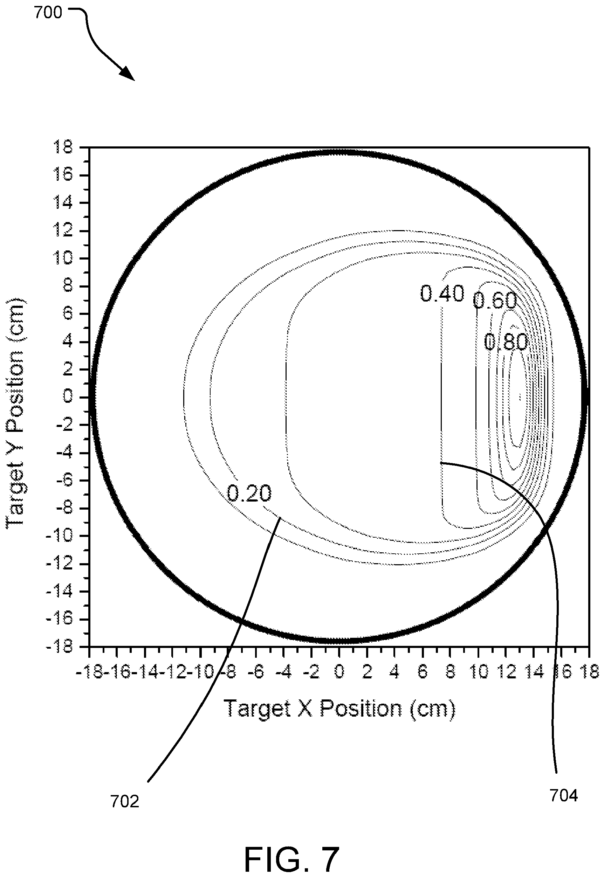

Steering of the ion beamlets in accordance with the contour plot illustrated in FIG. 5 allows the ion beam to be targeted on the work-piece surface to generate a desired ion beam density at various locations on the work-piece surface. The ion-beam density generated on the work-piece surface by the steering of the ion-beam according to FIG. 5 is further illustrated below in FIG. 7.

FIG. 6 illustrates another example beamlet steering diagram 600 using grid dishing and hole offsets. The diagram 600 is a combination of the beamlet steering provided by dishing and the beamlet steering provided by hole offsets (not shown). The beamlet steering diagram 600 illustrates beamlets generally being steered toward the top-center and the bottom-center of the ion beam exiting the grids when facing the grid surface (e.g., looking at the ion source 102 from within the ion beam 108 of FIG. 1). In FIG. 6, the arrows notify the direction of steering of ion beamlets at particular X-Y locations on the grid surface. The numerals (2, 4, 6, 8, and 10) in FIG. 6 illustrate the magnitude of steering (in degrees) of various ion beamlets at particular X-Y locations on the grid surface. Thus, for example, in one implementation, at an X-Y location 602 (at and around the center of the grid surface), the magnitude of steering is close to zero (0) degrees, whereas at an X-Y location 604, the magnitude of steering is four (4) degrees. Note that an entire arc 606 passing through the location 604 denotes locations where the magnitude of steering is equal to four (4) degrees. Thus, the plot-diagram 600, in effect, provides a contour plot of the magnitude of beamlet steering at various X-Y locations on the grid surface, together with the direction of such steering as depicted by the arrows.

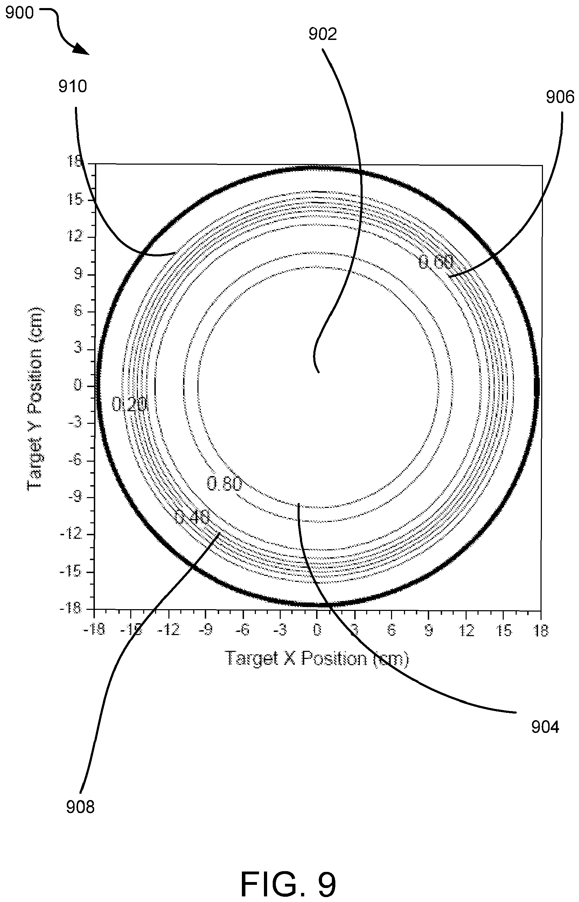

Steering of the ion beamlets in accordance with the contour plot illustrated in FIG. 6 allows the ion beam to be targeted on the work-piece surface to generate a desired ion beam density at various locations on the work-piece surface. The ion-beam density generated on the work-piece surface by the steering of the ion-beam according to FIG. 6 is further illustrated below in FIG. 9.

FIG. 7 illustrates an example single-peak ion current density profile 700 resulting from beamlet steering impinging on a work-piece. In one implementation, the ion current density profile 700 illustrates static ion current density at various X-Y locations on the destination work-piece of 45 degree tilt with respect to the ion source centerline when the ion current density upstream of the grid is uniform across the entire area of ion source and the ion beam, steered in the manner illustrated in FIG. 5, is targeted to the destination work-piece. The ion current density may be measured in mili-amperes (mA)/sq. cm, etc. However, FIG. 7 illustrates the ion current densities as fraction of the peak current density. More specifically, the ion current density profile 700 illustrates an ion beam cross-section having contour lines with numerals (i.e., 0.20, 0.40, 0.60, & 0.80 of peak value of unity) indicating the relative (or normalized) current density at X-Y locations on the destination work-piece. Thus, for example, an iso-density line 702 represents all X-Y locations on the destination work-piece where the ion current density from the ion beam is approximately 0.20, i.e., 20% of the peak current density. Similarly, an iso-density line 704 represents all X-Y locations on the destination work-piece where the ion current density from the ion beam is approximately 0.40, i.e., 40% of the peak current density.

The ion current density profile 700 is asymmetric and concentrated with a single-peak to the right side of the center of the surface as to the X-axis position and near the middle of the profile as to the Y-axis position of the work-piece assembly, when facing the work-piece assembly (e.g., looking at the work-piece assembly 116 from within the ion beam 108 of FIG. 1). This corresponds to the beamlets generally being steered toward the left side of the ion beam exiting the grids when facing the grid surface (e.g., looking at the ion source 102 from within the ion beam 108 of FIG. 1).\

If the destination work-piece receives the ion beam with the current density profile as illustrated by the plot diagram 700, it may be expected that the sputter material ejected from X-Y locations of the destination work-piece where the ion current density is higher, such as at a location on the iso-density line 704, will be higher than the sputter material ejected from X-Y locations where the ion current density is lower, such as at a location on the iso-density line 702. Such static application of ion-beam would result in uneven wear of the destination work-piece surface material. However, if the destination work-piece is rotated on its central axis, the integrated ion current density at various X-Y locations on the destination work-piece will generate a more uniform wear of the work-piece surface material.

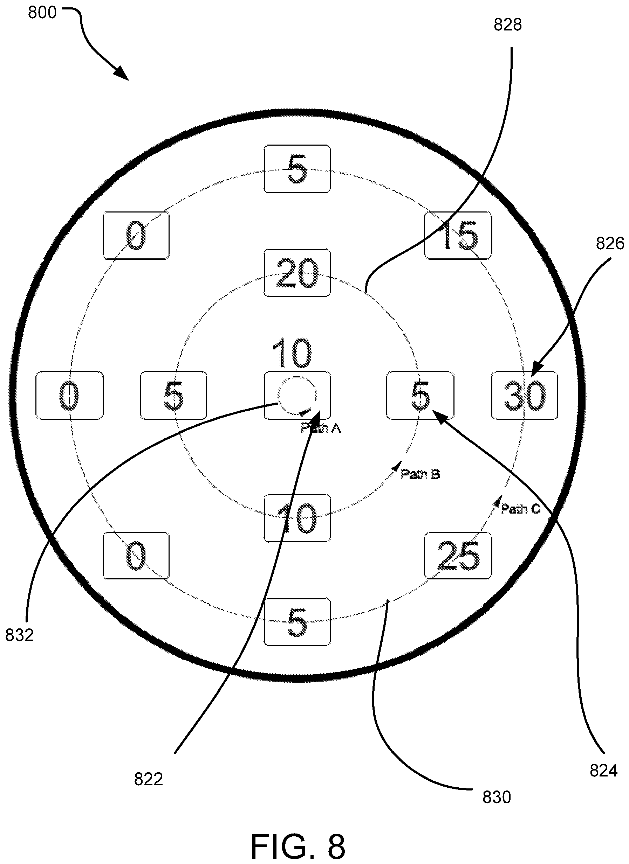

FIG. 8 illustrates the integrative effect of the rotation of the destination work-piece and resulting average ion current density at various locations on the destination work-piece. Specifically, the plot-diagram 800 illustrates how a static ion current density profile of a particular form may result in uniform ion current density on the destination work-piece. As illustrated in FIG. 8, the static ion-beam results in ion current density of 10 units at X-Y location 822, ion current density of 5 units at X-Y location 824, ion current density of 30 units at X-Y location 826, etc.

Due to the rotation of the destination work-piece, every point along a path 828 will be exposed to ion-current density of 5, 20, 5 and 10 units, each for equal amount of time, resulting in an average ion current density of 10 units per rotation. Similarly, every point along the path 830 will be exposed to ion-current density of 0, 0, 5, 15, 30, 25, 5 and 0 units, each for equal amount of time (however, in this case, each amount of time being less than for points along the inner path 828 because of the longer path length per rotation), resulting in an average ion current density of 10 units per rotation as well. Note that because each point along the path 832 is always exposed to an ion-current density of 10 units per rotation, it results in average ion current density of 10 units as well. Thus, in effect, an unevenly distributed ion current density profile in a static form may be used to generate substantially uniform ion-current density at each point of the destination work-piece when the work-piece is rotated. A similar resultant ion-current density profile is illustrated below in FIG. 9. In practice, there may be an infinite number of circular paths within an ion beam as well as an infinite number of current density data points.

Specifically, FIG. 9 illustrates a plot-diagram of destination work-piece integrative average ion current density profile resulting from the static ion current density profile as illustrated within FIG. 7. Note that while the resulting average ion current density distribution profile 800 illustrated in FIG. 8 is uniform (10 units) across the destination work-piece, in practice, such uniform distribution may be very difficult to achieve. The integrative average ion current density profile 900 illustrated in FIG. 9 has tapering ion current densities away from the center of the destination work-piece. Thus, at the center of the destination work-piece the average ion current density is uniformly and nearly equal to one unit, as illustrated by numeral 902. However, at each point along a path 904, the average ion current density is equal to 0.90 units. The average ion current density further decreases to 0.60 units at each point along a path 906, to 0.50 units at each point along a path 908, and to 0.10 units at each point along a path 910. However, the average ion current density profile 900 results in substantially uniform and provides higher wear of the destination work-piece surface sputter material.

For example, in one implementation, the average ion current density profile 900 results in more than sixty percent (60%) wear of the destination work-piece surface sputter material.

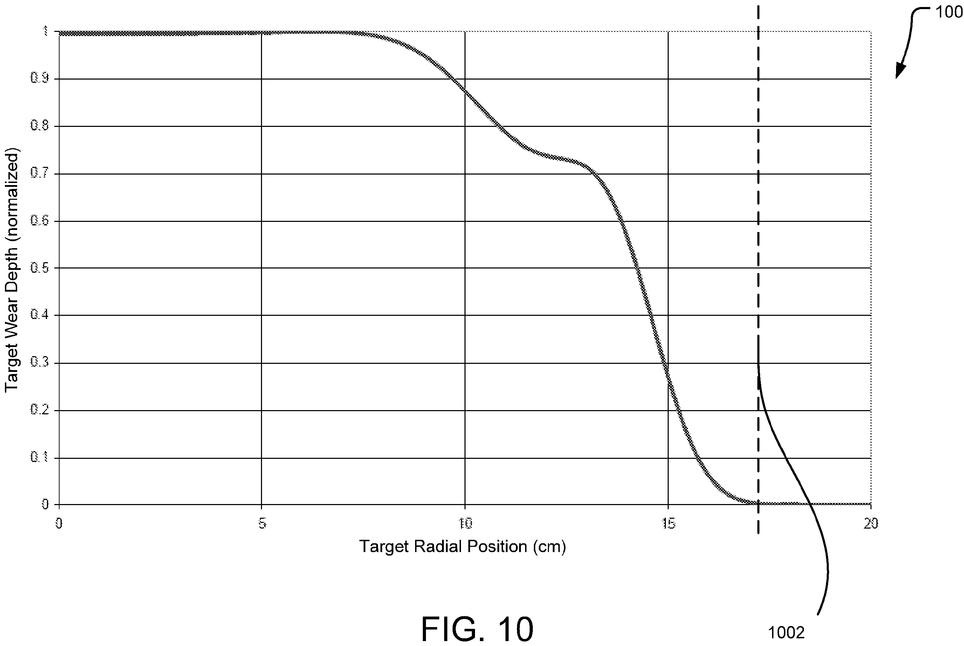

FIG. 10 illustrates an example graph 1000 of rotationally averaged wear pattern generated by an ion beam steered as a function of radius of the destination work-piece. Specifically, the graph 1000 illustrates the wear of the destination work-piece in the form of wear depth at various locations of the destination work-piece as a function of the radial distance of such locations from the center of the destination work-piece. The unit of wearing at various locations is normalized to a value of one (1) near the center of the destination work-piece. As shown in FIG. 10, the wear of the destination work-piece, as illustrated by wear depth, is uniform near the center and for first third of the total radial distance from the center of the destination work-piece. After that, the wear decreases towards the edge of the destination work-piece in a non-uniform manner until the radial distance denoted by dashed line 1002, beyond which the work-piece is minimally worn. Thus, the steering of an ion beam generates substantially uniform wear of the destination work-piece. In one implementation, the rotationally average wear depth of the destination work-piece, generated by the ion beam, is at least fifty percent (50%) of the maximum depth in each radial direction within at least fifty percent (50%) of the radial distance from the center of the destination work-piece. Furthermore, the wear of the destination work-piece surface sputter material, as measured by the volume generated by the rotation of the area, bounded by the graph 1000, the X-axis and the Y-axis, around the Y-axis would represent higher than sixty percent (60%) of the total wear if all the sputter material were utilized.

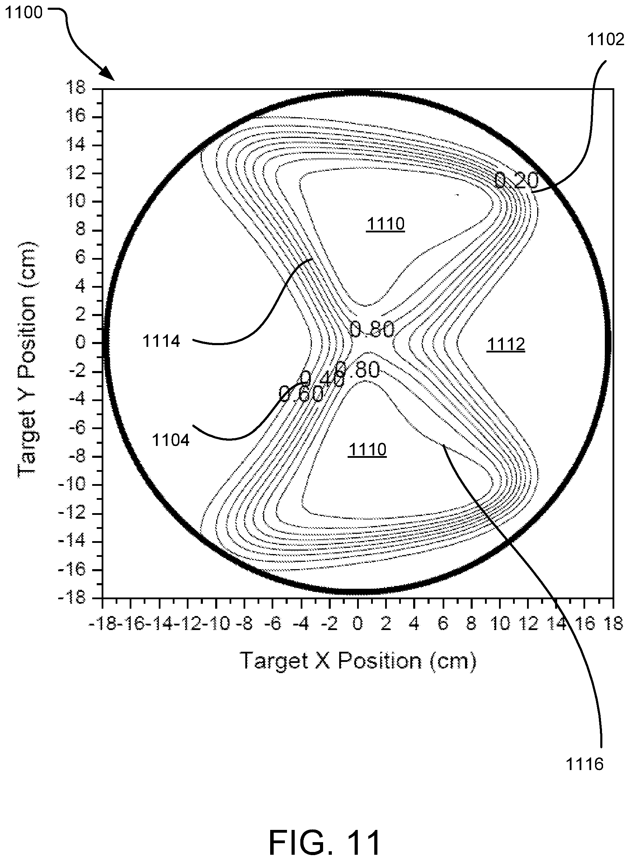

FIG. 11 illustrates an example multi-peak ion current density profile 1100 resulting from the beamlet steering impinging on a destination work-piece. In one implementation, the plot-diagram 1100 illustrates static ion current density at various X-Y locations on the destination work-piece tilted by 45 degrees with respect to the ion source centerline when the ion current density upstream of the grid is uniform across the entire area of ion source and the ion beam, steered in the manner illustrated in FIG. 6, is targeted to the destination work-piece. The ion current density may be measured in mili-amperes (mA)/sq. cm, etc. However, FIG. 11 illustrates the ion current densities as fraction of the peak current density. More specifically, the ion current density profile 1100 illustrates an ion beam cross-section having contour lines with numerals (i.e., 0.20, 0.40, 0.60, & 0.80 of peak value of unity) indicating the relative (or normalized) current density at X-Y locations on the destination work-piece. Thus, for example, an iso-density line 1102 represents all X-Y locations on the destination work-piece where the ion current density from the ion beam is 0.10, i.e., 10% of the peak current density. Similarly, an iso-density line 1104 represents all X-Y locations on the destination work-piece where the ion current density from the ion beam is 0.70, i.e., 70% of the peak current density.

The ion current density profile 1100 is circularly asymmetric and concentrated with peaks 1110 at the top-center and bottom-center (as to the X-axial distance) of the destination work-piece when facing the destination work-piece (e.g., looking at the work-piece assembly 116 from within the ion beam 108 of FIG. 1). This corresponds to the beamlets generally being steered toward the top-center and the bottom-center of the ion beam exiting the grids when facing the grid surface (e.g., looking at the ion source 102 from within the ion beam 108 of FIG. 1).

If the destination work-piece is receiving the ion beam with the current density profile as illustrated by the plot diagram 1100, it may be expected to generate higher amounts of sputter material at X-Y locations of the destination work-piece where the ion current density is higher compared to at X-Y locations where the ion current density is lower. Thus, for example, sputter material ejected at a location on the iso-density line 1116, will be higher than the sputter material ejected at X-Y locations where the ion current density is lower, such as at a location on the iso-density line 1102. Such static application of ion-beam would result in uneven wear of the destination work-piece surface material. However, if the destination work-piece is rotated on its central axis, the integrated ion current density at various X-Y locations on the destination work-piece will generate a more uniform wear of the destination work-piece surface material.

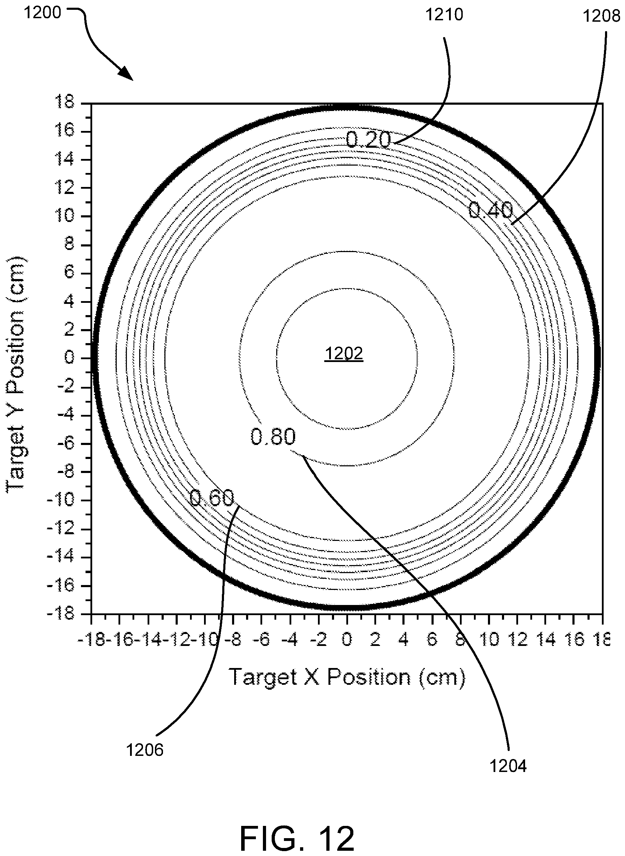

FIG. 12 illustrates a plot-diagram of destination work-piece integrative average ion current density profile resulting from the static ion current density profile illustrated in FIG. 11. The integrative average ion current density profile 1200 illustrated in FIG. 12 has tapering ion-beam densities away from the center of the destination work-piece. Thus, at the center of the destination work-piece the average ion current density is uniform and nearly equal to one unit, as illustrated by numeral 1202. However, at each point along a path 1204, the average ion current density is equal to 0.80 units. The average ion current density further decreases to 0.70 units at each point along a path 1206, to 0.30 units at each point along a path 1208, and to 0.20 units at each point along a path 1210. However, the average ion beam density profile 1200 results in substantially uniform and higher wear of the destination work-piece surface sputter material. For example, in one implementation, the average ion current density profile 1200 results in more than sixty percent (60%) wear of the destination work-piece surface sputter material.

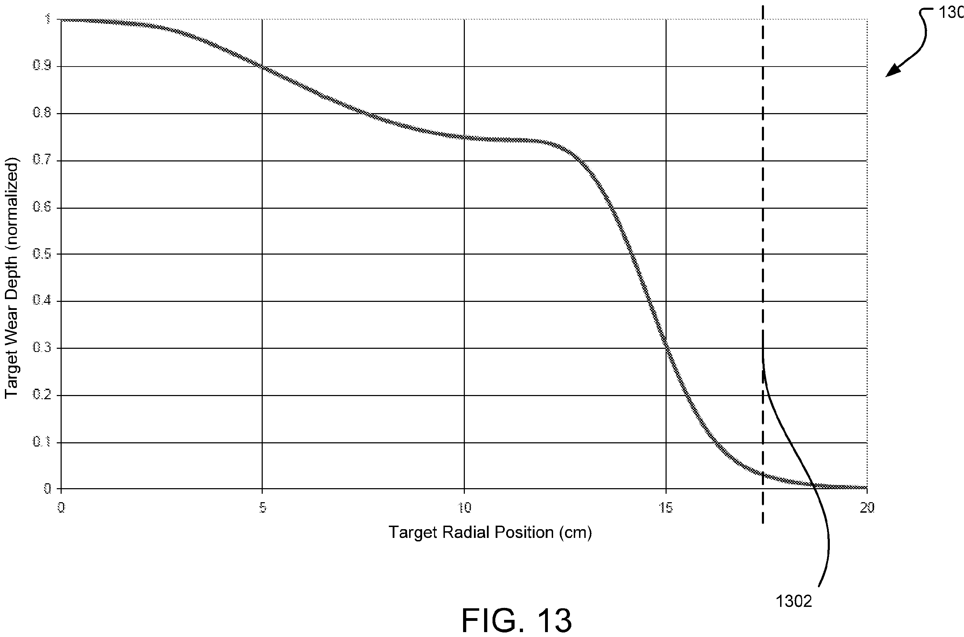

FIG. 13 illustrates an example graph 1300 of rotationally averaged wear pattern generated by the ion beam steered as described in FIG. 6 as a function of radius of the destination work-piece. Specifically, the graph 1300 illustrates the wear of the destination work-piece in the form of wear depth at various locations of the destination work-piece as a function of the radial distance of such locations from the center of the destination work-piece. The unit of wearing at various locations is normalized to a value of one (1) at the center of the destination work-piece. As shown in FIG. 13, the wear of the destination work-piece, as illustrated by wear depth, is relatively uniform near the center and for first quarter of the total radial distance from the center of the destination work-piece. After that, the wear decreases towards the edge of the destination work-piece in a non-uniform manner until the radial distance denoted by dashed line 1302, beyond which the work-piece is minimally worn. For example, as shown in FIG. 13, the rotationally average wear depth of the destination work-piece, generated by the ion beam, is less than twenty percent (20%) of the maximum wear depth in each radial direction at each radial distance at least ninety percent (90%) away (at radial distance of eighteen (18) cm in FIG. 13) from the center of the destination work-piece. Thus, the steering of the ion beam as illustrated in FIG.6 generates substantially uniform wear of the destination work-piece as illustrated in FIG. 13. In an implementation, as illustrated in FIG. 13 the slope of the wear depth of the destination work-piece declines non-monotonically in each radial direction away from the center of the destination work-piece. For example, the wear of the destination work-piece surface sputter material, as measured by the volume generated by the rotation of the area, bounded by the graph 1300, the X-axis and the Y-axis, around the Y-axis would represent higher than sixty percent (60%) of the total sputter material volume if all the sputter material were utilized. Whereas the implementations discussed above, ion beam having current density profiles with one or two peaks are disclosed, in an alternate implementation, other current density profiles having different number and form of peaks may also be used. A decision to use a particular current density profile may depend on a number of factors, including, but not limited to, desired deposition uniformity, desired wear patterns on a sputter work-piece, desired coverage on a sputter target, etc.

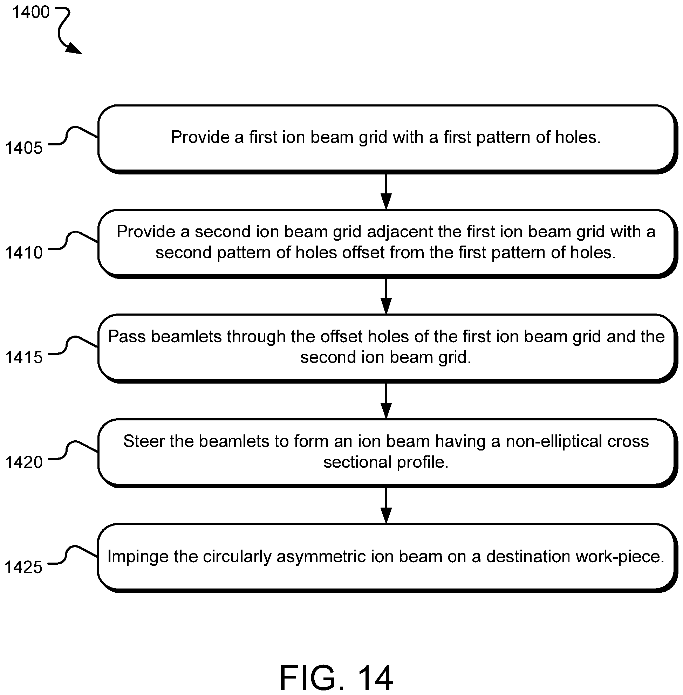

FIG. 14 illustrates example operations for generating substantially uniform destination work-piece wear. Specifically, FIG. 14 illustrates example operations 1400 for creating an ion beam with non-elliptical cross sectional profile adapted to impinge on a destination work-piece assembly. In a first providing operation 1405, a first ion beam grid with a first pattern of holes is provided. In a second providing operation 1410, a second ion beam grid with a second pattern of holes offset from the first pattern of holes is provided. The quantity and direction of offsets determine the quantity and direction of steering individual beamlets passing through corresponding holes in the first ion beam grid and the second ion beam grid. The beamlet steering as a whole creates a varied current density distribution within a cross-section of an ion beam. Further, one or both the ion beam grids may be dished. The dishing provides additional beamlet steering, primarily making the resulting ion beam divergent or convergent depending on whether the dishing is convex or concave, respectively.

In a passing operation 1415, beamlets are passed through the offset holes in the first ion beam grid and the second ion beam grid and directed toward a work-piece assembly. In a steering operation 1420, the beamlets are steered to form an ion beam having a non-elliptical cross sectional profile. The non-elliptical cross-sectional current density profile of the ion beam is chosen to result in relatively even wear on a rotating destination work-piece from which material is sputtered. In a first impinging operation 1425, the ion beam having a non-elliptical cross sectional profile is impinged on the work-piece assembly. When the ion beam impacts the work-piece assembly, material is sputtered from the work-piece assembly.

The implementations of the invention described herein may be implemented in any order, unless explicitly claimed otherwise or a specific order is inherently necessitated by the claim language. The above specification, examples, and data provide a complete description of the structure and use of example implementations of the invention. Since many implementations of the invention can be made without departing from the scope of the invention, the invention resides in the claims hereinafter appended. Furthermore, structural features of the different implementations may be combined in yet another implementation without departing from the recited claims.

## Claims

1.  A method comprising:
    steering a plurality of ion beamlets using a grid assembly (300), the grid assembly comprising:

    a screen grid;
    an acceleration grid positioned downstream of the screen grid; and
    a deceleration grid positioned downstream of the acceleration grid;

    each of the screen grid, acceleration grid and deceleration grid having an elliptical pattern of holes and wherein steering the plurality of ion beamlets further comprises steering the plurality of beamlets using offsets between corresponding holes in the screen grid and the acceleration grid so as to generate an ion beam (108), wherein ion current density profile of a cross-section of the ion beam is non-elliptical.

2.  The method of claim 1, wherein steering the plurality of ion beamlets further comprises propelling the plurality of ion beamlets from the grid assembly in an elliptically asymmetric distribution of steering angles.

3. The method of any one of the preceding claims, wherein the ion current density profile (900, 1200) of the cross-section of the ion beam (108) is symmetric as to one of two orthogonal axes of the cross-section.

4. The method of claim 3, wherein the ion current density profile (700, 1100) of the cross- section of the ion beam (108) is asymmetric as to another of the two orthogonal axes of the cross- section.

5. The method of any one of the preceding claims, further comprising directing an ion source (102) generating the plurality of ion beamlets toward a center of a destination work-piece (104), wherein the ion current density profile (700) of the cross-section of the ion beam has a single peak that is offset from the center of the destination work-piece.

6. The method of any one of the preceding claims, further comprising directing the ion beam on a rotating destination work-piece to generate a uniform rotationally average ion current density at each point equidistant from the center of the destination work-piece;
wherein rotationally average wear depth of the destination work-piece, generated by the ion beam, is at least 50% of a maximum wear depth in each radial direction within at least 50% of the radial distance from the center of the destination work-piece.

7. The method of any one of the preceding claims, wherein the ion current density profile (1100) of the cross- section of the ion beam has two peaks, wherein each of the two peaks are on opposite sides of one of two orthogonal axes of the cross-section.

8. The method of any one of the preceding claims, further comprising directing the ion beam on a destination work-piece, wherein the destination work-piece is one or more of a sputter work-piece, a substrate etch work-piece, an ion-implantation work-piece, an ion deposition work-piece, and an ion beam assisted deposition work-piece.

9. The method of claim 1, wherein steering the plurality of beamlets further comprises steering the plurality of beamlets using a screen grid (302) and an acceleration grid (304) of the grid assembly (300).

10. The method of any one of the preceding claims, wherein the elliptical pattern of holes is circular.

11. The method of any preceding claim, wherein ion beam comprises a plurality of beamlets, each individual beamlet passing through a corresponding hole in each of the screen grid, acceleration grid and deceleration grid and wherein the amount of steering in the manner of a steering angle β is given by the formula:

$$\beta \equiv \left(-\lambda / 4\eta_{g1}\right)\left(1 - (E_2 / E_1)\right)$$

where $E_1$ is calculated as [(voltage of the screen grid - voltage of the acceleration grid)/$\eta_{g1}$ and $E_2$ is calculated as [(voltage of the acceleration grid - voltage of the deceleration grid)/$\eta_{g2}$, where $E1$ and $E2$ are measured in volts/mm, $\lambda$ is a measure of the distance between the screen grid center axis and the acceleration grid center axis, $\eta_{g1}$ is a measure of the lateral distance between the screen grid and the acceleration grid and $\eta_{g2}$ is a measure of the lateral distance between the acceleration grid and the deceleration grid.

**Patentansprüche**

1. Verfahren, umfassend:
Lenken einer Mehrzahl von Ionenteilstrahlen unter Verwendung einer Gitteranordnung (300), die Gitteranordnung umfassend:

    ein Schirmgitter;
    ein Beschleunigungsgitter, das stromabwärts des Schirmgitters positioniert ist; und
    ein Abbremsgitter, das stromabwärts des Beschleunigungsgitters postioniert ist;

wobei jeweils das Schirmgitter, das Beschleunigungsgitter und das Abbremsgitter ein elliptisches Muster von Löchern aufweist, und wobei das Lenken der Mehrzahl von Ionenteilstrahlen ferner ein Lenken der Mehrzahl von Ionenteilstrahlen unter Verwendung von Versätzen zwischen entsprechenden Löchern im Schirmgitter und im Beschleunigungsgitter umfasst, so dass ein Ionenstrahl (108) erzeugt wird, wobei ein Ionenstromdichte-Profil eines Querschnitts des Ionenstrahls nicht elliptisch ist.

2. Verfahren nach Anspruch 1, wobei ein Lenken der Mehrzahl von Ionenteilstrahlen ferner ein Antreiben der Mehrzahl von Ionenteilstrahlen von der Gitteranordnung in einer elliptisch asymmetrischen Verteilung von Lenkwinkeln umfasst.

3. Verfahren nach einem der vorhergehenden Ansprüche, wobei das Ionenstromdichte-Profil (900, 1200) des Querschnitts des Ionenstrahls (108) symmetrisch in Bezug auf eine von zwei orthogonalen Achsen des Querschnitts ist.

4. Verfahren nach Anspruch 3, wobei das Ionenstromdichte-Profil (700, 1100) des Querschnitts des Ionenstrahls (108) asymmetrisch in Bezug auf eine andere der zwei orthogonalen Achsen des Querschnitts ist.

5. Verfahren nach einem der vorhergehenden Ansprüche, das ferner ein Richten einer Ionenquelle (102), die die Mehrzahl von Ionenteilstrahlen erzeugt, in Richtung eines Zentrums eines Ziel-Werkstücks (104) umfasst, wobei das Ionenstromdichte-Profil (700) des Querschnitts des Ionenstrahls eine einzelne Spitze aufweist, die vom Zentrum des Ziel-Werkstücks versetzt ist.

6. Verfahren nach einem der vorhergehenden Ansprüche, das ferner ein Richten des Ionenstrahls auf ein sich drehendes Ziel-Werkstück zur Erzeugung einer einheitlichen drehend durchschnittlichen Ionenstromdichte an jedem Punkt abstandsgleich vom Zentrum des Ziel-Werkstücks umfasst;
wobei eine drehend durchschnittliche Verschleißtiefe des Ziel-Werkstücks, die von dem Ionenstrahl erzeugt wird, wenigstens 50% einer maximalen Verschleißtiefe in jeder radialen Richtung innerhalb von wenigstens 50% des radialen Abstands vom Zentrum des Ziel-Werkstücks beträgt.

7. Verfahren nach einem der vorhergehenden Ansprüche, wobei das Ionenstromdichte-Profil (1100) des Querschnitts des Ionenstrahls zwei Spitzen aufweist, wobei jede der beiden Spitzen auf entgegengesetzten Seiten von einer von zwei orthogonalen Achsen des Querschnitts ist.

8. Verfahren nach einem der vorhergehenden Ansprüche, das ferner ein Richten des Ionenstrahls auf ein Ziel-Werkstück umfasst, wobei das Ziel-Werkstück eines oder mehrere eines Sputter-Werkstücks, eines Substrat-Ätz-Werkstücks, eines Ionenimplantations-Werkstücks, eines Ionenabscheidungs-Werkstücks und eines Ionenstrahl unterstützte Abscheidungs-Werkstücks ist.

9. Verfahren nach Anspruch 1, wobei das Lenken der Mehrzahl von Teilstrahlen ferner ein Lenken der Mehrzahl von Teilstrahlen unter Verwendung eines Schirmgitters (302) und eines Beschleunigungsgitters (304) der Gitteranordnung (300) umfasst.

10. Verfahren nach einem der vorhergehenden Ansprüche, wobei das elliptische Muster von Löchern kreisrund ist.

11. Verfahren nach einem der vorhergehenden Ansprüche, wobei der Ionenstrahl eine Mehrzahl von Teilstrahlen umfasst, wobei jeder individuelle Teilstrahl durch ein entsprechendes Loch in jedem des Schirmgitters, des Beschleunigungsgitters und des Abbremsgitters verläuft und wobei die Menge des Lenkens in der Art eines Lenkwinkels $\beta$ durch folgende Formel dargestellt ist:

$$\beta \equiv \left( -\lambda / 4\eta_{g1} \right)\left( 1 - \left( E_2 / E_1 \right) \right)$$

wobei $E_1$ als [(Spannung des Schirmgitters - Spannung des Beschleunigungsgitters)/$\eta_{g1}$ berechnet wird, und $E_2$ als [(Spannung des Beschleunigungsgitters - Spannung des Abbremsgitters)/$\eta_{g2}$ berechnet wird, wobei $E1$ und $E2$ in Volt/mm gemessen werden, $\lambda$ ein Maß des Abstands zwischen der Zentrumsachse des Schirmgitters und der Zentrumsachse des Beschleunigungsgitters ist, $\eta_{g1}$ ein Maß des seitlichen Abstands zwischen dem Schirmgitter und dem Beschleunigungsgitter ist und $\eta_{g2}$ ein Maß des seitlichen Abstands zwischen dem Beschleunigungsgitter und dem Abbremsgitter ist.

**Revendications**

1. Procédé comprenant :
diriger une pluralité de petits faisceaux d'ions à l'aide d'un ensemble grille (300), l'ensemble grille comprenant :

une grille écran ;
une grille d'accélération positionnée en aval de la grille écran ; et
une grille de décélération positionnée en aval de la grille d'accélération ;
chacune parmi la grille écran, la grille d'accélération et la grille de décélération ayant un motif elliptique de trous, et la direction de la pluralité de petits faisceaux d'ions comprenant en outre diriger la pluralité de petits faisceaux à l'aide de décalages entre des trous correspondants dans la grille écran et la grille d'accélération de façon à générer un faisceau d'ions (108), un profil d'intensité de courant ionique d'une section transversale du faisceau d'ions étant non-elliptique.

2. Procédé selon la revendication 1, dans lequel la direction de la pluralité de petits faisceaux d'ions comprend en outre propulser la pluralité de petits faisceaux d'ions à partir de l'ensemble grille dans une distribution asymétrique elliptique d'angles de direction.

3. Procédé selon l'une quelconque des revendications précédentes, dans lequel le profil de densité de courant ionique (900, 1200) de la section transversale du faisceau d'ions (108) est symétrique par rapport à l'un parmi deux axes orthogonaux de la section transversale.

4. Procédé selon la revendication 3, dans lequel le profil de densité de courant ionique (700, 1100) de la section transversale du faisceau d'ions (108) est asymétrique par rapport à l'autre parmi les deux axes orthogonaux de la section transversale.

5. Procédé selon l'une quelconque des revendications précédentes, comprenant en outre diriger une source d'ions (102) générant la pluralité de petits faisceaux d'ions vers un centre d'une pièce cible (104), le profil de densité de courant ionique (700) de la section transversale du faisceau d'ions ayant un unique pic qui est décalé par rapport au centre de la pièce cible.

6. Procédé selon l'une quelconque des revendications précédentes, comprenant en outre diriger le faisceau d'ions sur une pièce cible rotative pour générer une densité de courant ionique moyenne uniforme en rotation à chaque point équidistant du centre de la pièce cible ;
la profondeur d'usure moyenne en rotation de la pièce cible, générée par le faisceau d'ions, étant au moins 50 % d'une profondeur d'usure maximale dans chaque direction radiale dans les limites d'au moins 50 % de la distance radiale du centre de la pièce cible.

7. Procédé selon l'une quelconque des revendications précédentes, dans lequel le profil de densité de courant ionique (1100) de la section transversale du faisceau d'ions a deux pics, et chacun des deux pics se trouvant sur des côtés opposés de l'un parmi deux axes orthogonaux de la section transversale.

8. Procédé selon l'une quelconque des revendications précédentes, comprenant en outre diriger le faisceau d'ions sur une pièce cible, la pièce cible étant au moins une parmi une pièce de pulvérisation, une pièce de gravure de substrat, une pièce d'implantation d'ions, une pièce de dépôt d'ions et une pièce de dépôt assisté par faisceau d'ions.

9. Procédé selon la revendication 1, dans lequel la direction de la pluralité de petits faisceaux comprend en outre diriger la pluralité de petits faisceaux à l'aide d'une grille écran (302) et d'une grille d'accélération (304) de l'ensemble grille (300).

10. Procédé selon l'une quelconque des revendications précédentes, dans lequel le motif elliptique de trous est circulaire.

11. Procédé selon l'une quelconque des revendications précédentes, dans lequel un faisceau d'ions comprend une pluralité de petits faisceaux, chaque petit faisceau individuel passant à travers un trou correspondant dans chacune parmi la grille écran, la grille d'accélération et la grille de décélération, et l'amplitude de direction à un angle de direction β étant donnée par la formule :

$$\beta \equiv \left(-\lambda / 4\eta_{g1}\right)\left(1 - (E_2 / E_1)\right)$$

$E_1$ étant calculé en tant que [(tension de la grille écran - tension de la grille de décélération) / $\eta_{g1}$ et $E_2$ étant calculé en tant que [(tension de la grille d'accélération - tension de la grille de décélération/$\eta_{g2}$, $E_1$ et $E_2$ étant mesurés en volts/mm, $\lambda$ étant une mesure de la distance entre l'axe central de grille écran et l'axe central de grille d'accélération, $\eta_{g1}$ étant une mesure de la distance latérale entre la grille écran et la grille d'accélération, et $\eta_{g2}$ étant une mesure de la distance latérale entre la grille d'accélération et la grille de décélération.

FIG. 1

FIG. 2

FIG. 3

FIG. 4

FIG. 5

FIG. 6

EP 2 625 305 B1

FIG. 7

23

FIG. 8

FIG. 9

EP 2 625 305 B1

FIG. 10

FIG. 11

FIG. 12

EP 2 625 305 B1

FIG. 13

1400

1405 — Provide a first ion beam grid with a first pattern of holes.

1410 — Provide a second ion beam grid adjacent the first ion beam grid with a second pattern of holes offset from the first pattern of holes.

1415 — Pass beamlets through the offset holes of the first ion beam grid and the second ion beam grid.

1420 — Steer the beamlets to form an ion beam having a non-elliptical cross sectional profile.

1425 — Impinge the circularly asymmetric ion beam on a destination work-piece.

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 89828110 A
- US 89842410 A
- US 89835110 A

- WO 2005024881A2 A
- WO 2005038855A2 A